# EUROPÄISCHE PATENTSCHRIFT

(11) **EP 2 667 212 B1**
(45) Veröffentlichungstag und Bekanntmachung des Hinweises auf die Patenterteilung: **22.03.2017**
(21) Anmeldenummer: 13168725.3
(22) Anmeldetag: 22.05.2013
(51) Int. Cl.: H05B 33/08, G01R 31/36

(54) **Verfahren für die Bestimmung des Ladezustandes eines Energiespeichers**
Method for determining the state of charge of an energy storage device
Procédé de détermination de l'état de charge d'un accumulateur d'énergie

(30) Priorität: 23.05.2012 DE 102012104434
(43) Veröffentlichungstag der Anmeldung: 27.11.2013
(73) Patentinhaber: Hella KGaA Hueck & Co., 59552 Lippstadt (DE)
(72) Erfinder: Tillmann, Rebecca, 59609 Anröchte (DE); Sauer, Dirk-Uwe, 52146 Würselen (DE); Waag, Wadislaw, 80992 München (DE)

(56) Entgegenhaltungen:
- US-A1- 2010 201 323
- US-B2- 7 990 111

## Beschreibung

Die vorliegende Erfindung betrifft ein Verfahren für die Bestimmung des Ladestandes eines Energiespeichers während des Ladevorganges des Energiespeichers sowie eine Kontrollvorrichtung für die Bestimmung des Ladestandes eines Energiespeichers während des Ladevorganges des Energiespeichers.

Verfahren für die Bestimmung des Ladestandes eines Energiespeichers sind grundsätzlich bekannt. Sie werden z. B. in Form von so genannten OCV-Verfahren (open circuit voltage) eingesetzt, um den aktuellen Ladestand eines Energiespeichers zu bestimmen. Dies erfolgt üblicherweise dadurch, dass die Ruhespannung des Energiespeichers an den beiden Polen abgegriffen wird. Aus dem Wert der Ruhespannung kann ein Rückschluss auf den Ladestand gezogen bzw. dieser bestimmt werden. Eine grundsätzliche Möglichkeit zur Bestimmung des Ladestandes eines Energiespeichers ist z. B. aus der EP 1 150 131 B1 bekannt.

Weitere Beispiele zur Bestimmung des Ladezustandes eines Energiespeichers sind in US 2010/0201323 A1 und in US 7,990,111 B2 beschrieben.

Nachteilhaft ist es jedoch, dass insbesondere bei Fahrzeugen, welche Energiespeicher in Form von Batterien aufweisen, die Bestimmung eines Ladestandes dieses Energiespeichers durch ein OCV-Verfahren in bestimmten Einsatzsituationen nicht oder nur sehr ungenau möglich ist. Insbesondere bei Fahrzeugbetriebsweisen, welche mit nur geringen Ruhephasen ohne jeglichen Verbraucher ausgebildet sind, ist die Durchführung eines OCV-Verfahrens nur schwer oder überhaupt nicht möglich. Dies sind z. B. Taxi-Betriebsweisen oder LKW-Betriebsweisen, bei welchen das Fahrzeug auch im Stand elektrische Verbraucher wie Radio, Navigationssystem, Funkgerät, Kühlschrank oder ähnliches betreibt. Damit ist ein ständiger Energiefluss ausgehend vom Energiespeicher vorhanden, so dass eine Ruhespannungssituation zum Abgreifen der Ruhespannung nicht vorliegt. In einem solchen Fall ist es für eine Kontrollvorrichtung ungenau beziehungsweise schwierig den Ladestand des Energiespeichers zu bestimmen.

Es ist Aufgabe der vorliegenden Erfindung, die voranstehend beschriebenen Nachteile bekannter Verfahren und Kontrollvorrichtungen zumindest teilweise zu beheben. Insbesondere ist es Aufgabe der vorliegenden Erfindung, ein Verfahren für die Bestimmung des Ladestandes eines Energiespeichers während des Ladevorganges des Energiespeichers sowie eine entsprechende Kontrollvorrichtung für die Bestimmung des Ladestandes eines Energiespeichers während des Ladevorganges des Energiespeichers zur Verfügung zu stellen, welche in kostengünstiger und einfacher Weise eine Bestimmung des Ladestandes des Energiespeichers unabhängig von der Ruhespannung ermöglichen.

Voranstehende Aufgabe wird gelöst durch ein Verfahren mit den Merkmalen des Anspruchs 1 sowie durch eine Kontrollvorrichtung mit den Merkmalen des Anspruchs 9. Weitere Merkmale und Details der Erfindung ergeben sich aus den Unteransprüchen, der Beschreibung und den Zeichnungen. Dabei gelten Merkmale und Details, die im Zusammenhang mit dem erfindungsgemäßen Verfahren beschrieben sind, selbstverständlich auch im Zusammenhang mit der erfindungsgemäßen Kontrollvorrichtung und jeweils umgekehrt, so dass bzgl. der Offenbarung zu den einzelnen Erfindungsaspekten stets wechselseitig Bezug genommen wird bzw. werden kann.

Ein erfindungsgemäßes Verfahren dient der Bestimmung des Ladestandes eines Energiespeichers während des Ladevorganges des Energiespeichers. Ein erfindungsgemäßes Verfahren weist die folgenden Schritte auf:
- Überwachen der Ladespannung,
- Bestimmen eines Zeitabschnittes mit im Wesentlichen konstanter Ladespannung,
- Bestimmen der Ladestromsteigung und des Ladestroms in dem Zeitabschnitt mit im Wesentlichen konstanter Ladespannung,
- Bestimmen von Ladestandwerten des Energiespeichers aus Kalibrationskurven der Ladestromsteigung und des Ladestroms mit den bestimmten Werten der Ladestromsteigung und des Ladestroms,
- Erzeugen eines Minimalwertes aus den bestimmten Ladestandwerten als Ladestand des Energiespeichers.

Ein erfindungsgemäßes Verfahren wird vorzugsweise nicht im Ruhezustand des Energiespeichers sondern vielmehr während des Ladevorganges des Energiespeichers eingesetzt. Ein Energiespeicher kann im Rahmen der vorliegenden Erfindung insbesondere ein elektrischer Energiespeicher sein. Dabei handelt es sich vorzugsweise um eine Batterie oder einen Kondensator oder eine Kombination oder eine größere Anzahl derselben. Als Batterie ist vorzugsweise eine Blei-Säure-Batterie und/oder eine Lithium-Ionen-Batterie vorgesehen. Selbstverständlich kann ein erfindungsgemäßer Energiespeicher auch mehr als eine einzelne Batterie insbesondere mehr als eine einzelne Batteriezelle aufweisen. Für die Überwachung der Ladespannung wird insbesondere die gemessene Ladespannung gefiltert, um ein Messrauschen herauszufiltern. Die Bestimmung der Ladestandwerte des Energiespeichers erfolgt vorzugsweise in Abhängigkeit von der Ladespannung und der Temperatur.

Ein erfindungsgemäßes Verfahren während des Ladevorganges unterscheidet sich von einem bekannten Verfahren zur Bestimmung des Ladestandes im Ruhezustand. Somit kann ein solches Verfahren als Alternative eingesetzt werden, z. B. ergänzend, oder für den Fall, dass zu selten ein Ruhezustand vorliegt, um den Ladezustand eines Energiespeichers in bekannter Weise festzustellen. Dabei erfolgt das erfindungsgemäße Verfahren im Kern durch einen Vergleich mit Kalibrationskurven. Verglichen werden Ladestrom in Relation zur Kapazität, insbesondere unabhängig von der Batteriegröße, und Ladestromsteigung in Zeitabschnitten mit im Wesentlichen konstanter Ladespannung, vorzugsweise abhängig von Spannungslage und Temperatur. Hierfür sind als Grundlage für das Verfahren die entsprechenden Kalibrationskurven notwendig. Sie können z. B. auf Prüfständen erzeugt werden. So kann der Energiespeicher unter definierten Umgebungsbedingungen, insbesondere unter definierter Umgebungstemperatur, definiertem Umgebungsdruck und/oder definierter Ladespannung, geladen werden. Die Umgebungstemperatur wird vorzugsweise als Eingangsgröße für ein Temperaturmodel verwendet, welches die tatsächliche Temperatur der Batterie abschätzt. Dabei wird über die einzelnen Ladestufen, also über die einzelnen Ladestände des Energiespeichers sowohl der abgenommene Ladestrom, als auch die Ladestromsteigung ermittelt. Diese beiden Werte über die Dauer des Ladezyklus werden graphisch über den Ladestand aufgetragen. So liegen nur zwei Kalibrationskurven, insbesondere sogar zwei Kalibrationsflächen (für mehrere Ladespannungen) vor, welche spezifisch für den jeweiligen Energiespeicher sind.

Wird durch ein erfindungsgemäßes Verfahren während des Ladevorganges eine Bestimmung des Ladestandes des Energiespeichers gewünscht, so wird die Ladespannung überwacht und nach im Wesentlichen konstanter Ladespannung gesucht. Wird ein Zeitabschnitt erkannt, in welchem im Wesentlichen konstante Ladespannung vorliegt, so wird für diesen Zeitabschnitt sowohl der Ladestrom in Relation zur Kapazität, als auch die Ladestromsteigung bestimmt. Diese beiden Werte für Ladestrom und Ladestromsteigung können wiederum in die Kalibrationskurven, vorzugsweise unter Berücksichtigung von Spannungslage und Temperatur, spezifisch für den Energiespeicher eingesetzt werden, so dass, sozusagen in umgekehrter Richtung, aus den bestimmten Werten des Ladestroms und der Ladestromsteigung über die Kalibrationskurven der Ladestand rückgeschlossen werden kann. Da es sich bei diesem Vergleich vorzugsweise um eine mathematisch bzw. physikalisch eher ungenaue Variante zur Bestimmung des Ladestandes des Energiespeichers handelt, wird erfindungsgemäß zum Beispiel ein Minimalwert aus den beiden bestimmten Ladestandwerten als Ladestand für den Energiespeicher gesetzt. Damit wird sichergestellt, dass eine Überbewertung des Ladestandes des Energiespeichers mit hoher Wahrscheinlichkeit vermieden wird. Mit anderen Worten dienen Ladestromsteigung und Ladestrom separat zur Erzeugung jeweils eines eigenen Wertes für den Ladestandwert des Energiespeichers, so dass aus diesen beiden Ladestandwerten ein Minimalwert gebildet werden kann. Wird mehr als ein Zeitabschnitt mit im Wesentlichen konstanter Ladespannung bestimmt, können dementsprechend auch ein Vielfaches von Werten für Ladestromsteigung und Ladestrom und dementsprechend eine Vielzahl von Ladestandwerten für die Minimalauswertung zur Verfügung gestellt werden. Vorzugsweise werden der Ladestrom und/oder die Ladestromsteigung kontinuierlich über den Verlauf des Ladevorgangs des Energiespeichers überwacht bzw. gespeichert.

Unter einem Zeitabschnitt mit im Wesentlichen konstanter Ladespannung ist insbesondere eine Zeit von 5 bis 10 Minuten zu verstehen. Eine konstante Ladespannung ist insbesondere dann gegeben, wenn die Spannung, insbesondere der gefilterte Wert der Spannung, um weniger als +-3 x 10⁻⁴ schwankt. Je nach Ergebnis der Durchführung des erfindungsgemäßen Verfahrens kann anschließend bei geringerem Ladestand als gewünscht bzw. bei erhöhtem Spannungsbedarf ein Laden mit veränderter Spannungsvorgabe z. B. mit 14,4V oder bis zu 15V oder auch mit zum Beispiel 13V im Fahrzeug erfolgen.

Ein erfindungsgemäßes Verfahren dient insbesondere dazu, den realen Ladestand zu erfassen. Dieser weicht insbesondere von dem optimalen Ladestand unter Nennbedingungen ab. So sind je nach Temperatursituation unterschiedliche Ladestände grundsätzlich erreichbar. Auch der Alterungszustand und die damit einhergehende Restkapazität des Energiespeichers stellen grundlegende Faktoren für Veränderungen des maximal möglichen Ladestands des Energiespeichers dar. All diese veränderlichen Faktoren werden durch ein erfindungsgemäßes Verfahren berücksichtigt, so dass eine reale Ladesituation und damit ein realer Ladestand des Energiespeichers bestimmt wird. Dieser kann insbesondere auch in Beziehung gesetzt werden mit auf andere Weise bestimmten Ladeständen, insbesondere mit Ladeständen bezogen auf den Nennwert des Energiespeichers. Vorzugsweise wird für die Bestimmung des Ladestandes nach dem erfindungsgemäßen Verfahren als Referenzgröße die real mögliche Kapazität in Abhängigkeit der Umgebungsparameter gewählt. Für einen Vergleich mit bekannten Verfahren erfolgt eine Rückrechnung auf die Bezugsgröße der Nennkapazität der Batterie.

Ein erfindungsgemäßes Verfahren kann dahingehend weitergebildet sein, dass der Energiespeicher eine Batterie ist, insbesondere in Form einer Blei-Säure-Batterie. Auch Kondensatoren sind alternativ oder zusätzlich für den Energiespeicher denkbar. Selbstverständlich kann grundsätzlich auch eine Lithium-Ionen-Batterie als Batterie eingesetzt werden. Bei einem Energiespeicher in Form einer Batterie ist es insbesondere vorteilhaft die reale Ladestandsituation zu kennen, um elektrochemischen Verfallsprozessen bzw. Alterungsprozessen vorbeugen zu können. Insbesondere sei hier die Sulfatierung bei einer Blei-Säure-Batterie genannt. Der Alterung kann zum Beispiel durch Ladespannungsempfehlung vorgebeugt werden. Es ist auch im Wesentlichen möglich, eine entstandene Sulfatierung, die durch dieses Verfahren detektiert wird, durch geeignete Ladestrategien wieder zu reduzieren.

Ein weiterer Vorteil kann dadurch erzielt werden, dass bei einem erfindungsgemäßen Verfahren die Länge des Zeitabschnittes größer oder gleich 5 Minuten, bevorzugt größer oder gleich 6 Minuten, besonders bevorzugt größer oder gleich 7 Minuten, insbesondere größer oder gleich 8 Minuten beträgt. Diese besonders definierte Mindestlänge des Zeitabschnittes führt dazu, dass eine qualitativ verwertbare Aussage für den gewünschten Vergleich mit den Kalibrationskurven durchführbar ist. Insbesondere erfolgt eine geeignete Wahl des Zeitabschnitts. So wird es möglich auch mehr als einen Zeitabschnitt in erfindungsgemäßer Weise zu bestimmen, so dass auch dementsprechend mehr Werte für den Ladestrom und die Ladestromsteigung zur Verfügung gestellt werden können und das erfindungsgemäße Verfahren mehrfach zur Ausführung kommen kann. So kann eine laufende Überwachung des Ladestandes der Batterie über den Verlauf des Ladezyklus erfolgen.

Ein weiterer Vorteil ist es, wenn bei einem erfindungsgemäßen Verfahren eine Temperaturkompensation durchgeführt wird, bei welcher der bestimmte Ladestand des Energiespeichers mit Bezug zur gemessenen Temperatur des Energiespeichers angepasst wird. Beispielsweise ist es möglich, in Form der Temperaturkompensation pro °C unter 25°C Umgebungstemperatur den ermittelten bzw. erzeugten Minimalwert als Ladestand des Energiespeichers um 1% zu reduzieren. Auch damit kann eine Anpassung an die reale Umgebungssituation erfolgen. Für diese Ausführungsform ist vorzugsweise ein entsprechender Temperatursensor vorgesehen, der einen Eingangswert als Umgebungstemperatur oder aus einem Temperaturmodel die Batterietemperatur für diese Temperaturkompensation zur Verfügung stellt. Vorteilhaft ist es weiter, wenn bei einem erfindungsgemäßen Verfahren eine Vollladestanderkennung des Energiespeichers durchgeführt wird. Dies erfolgt dadurch, dass bei Annäherung der bestimmten Ladestromsteigung gegen Null, insbesondere einem kleinen absoluten Stromwert, insbesondere in Relation zur Kapazität, der Energiespeicher vorzugsweise unter aktuellen Bedingungen unter Berücksichtigung von Temperatur und Ladespannung als vollgeladen bestimmt wird. Auch hier handelt es sich um eine Vollladung mit Bezug auf die reale Ladestandsituation des Energiespeichers. Bezogen auf die Nennleistung ist dies in den seltensten Fällen 100% des maximal möglichen Ladestandes des Energiespeichers. Insbesondere bei Einsatzsituationen, welche Wenigfahrer von Kraftfahrzeugen erzeugen, also bei Fahrzeugen, welche selten und/oder nur kurze Strecken bewegt werden, kann auf diese Weise ein Refresh-Zyklus angesetzt werden. Von einer Kontrollvorrichtung kann z. B. eine Erhöhung der Ladespannung vorgegeben werden, so dass mit der vollständig zur Verfügung stehenden Bordspannung von z. B. 14,4V eine Vollladung bzw. der gesamte Ladezyklus gefahren werden kann. Eine Erkennung der Vollladung erfolgt zum Beispiel unter der Berücksichtigung des Absolutwertes der Ladespannung als auch der Elektrolyttemperatur. Zur Erkennung der Vollladung ist ebenfalls eine annähernd konstante Ladespannung erforderlich.

Ein weiterer Vorteil ist es, wenn bei einem erfindungsgemäßen Verfahren zumindest eine Kalibrationskurve als mathematische Funktion vorgesehen ist, um durch Einsetzen des zugehörigen bestimmten Wertes der Ladestromsteigung und/oder des Ladestroms in diese mathematische Funktion den zugehörigen Ladestandwert des Energiespeichers zu bestimmen. Mit anderen Worten wird eine Formel verwendet, welche eine graphische Ausbildung der Kalibrationskurve vermeidet. Die Kalibrationskurve kann also grundsätzlich im Rahmen der vorliegenden Erfindung sowohl graphischer Natur als auch mathematisch-formelhafter Natur sein. Das Einsetzen in eine solche Formel kann durch eine einfache Recheneinheit durchgeführt werden, so dass mit entsprechendem Rechenaufwand besonders schnell und besonders genau der entsprechende Ladestandwert erzeugt werden kann. Selbstverständlich sind für Ladestromsteigung und Ladestrom sowohl die gleichen, als auch unterschiedliche Varianten der Bestimmung möglich. So kann für die Ladestromsteigung beispielsweise die Kalibrationskurve in graphischer Weise, und für den Ladestrom in mathematischer Weise vorgesehen sein wie auch umgekehrt.

Ebenfalls vorteilhaft ist es, wenn bei einem erfindungsgemäßen Verfahren eine Bestimmung der Kapazität des Energiespeichers durchgeführt wird, indem der bestimmte Ladestand des Energiespeichers mit einem aus der Ruhespannung und einer Ah-Bilanz bestimmten Ladestand des Energiespeichers verglichen wird. Es sind hier auch noch andere Verfahren für die Bestimmung des Ladestandes der Batterie denkbar. Dies kann insbesondere zur Erkennung der Alterung des Energiespeichers verwendet werden. Mit anderen Worten wird vorzugsweise der reale Ladestand mit einem theoretisch möglichen Ladestand, bezogen auf die Nennleistung verglichen. Dieser Vergleich beruht insbesondere auf dem Unterschied der Referenzgröße, nämlich der Nennkapazität oder der Realkapazität. Dieser Vergleich führt dazu, dass, insbesondere mit Bezug auf die entsprechenden Umgebungsparameter wie zum Beispiel die Temperatur, eine Alterungssituation ermittelt werden kann. Damit kann festgestellt werden, dass beispielsweise die maximal mögliche Kapazität der Batterie bzw. des Energiespeichers über eine Vielzahl von Zyklen gesunken ist. Auch eine solche Information kann durch ein erfindungsgemäßes Verfahren zur Verfügung gestellt werden, so dass z. B. Austauschzyklen bzw. ein real notwendiger Austausch eines Energiespeichers in einem Fahrzeug von einer Kontrollvorrichtung erkannt und angezeigt werden können.

Ebenfalls von Vorteil kann es sein, wenn bei einem erfindungsgemäßen Verfahren bei der Bestimmung von wenigstens zwei Zeitabschnitten mit im Wesentlichen konstanter Ladespannung der mit Bezug auf die Dauer des Ladezyklus des Energiespeichers spätere Zeitabschnitt für die weiteren Schritte des Verfahrens verwendet wird. Selbstverständlich können auch alle Zeitabschnitte verwendet werden und dementsprechend eine höhere Anzahl von Parametern bzw. Werten für Ladestrom und Ladestromsteigung in die entsprechenden Kalibrationskurven eingesetzt werden. Wird eine Verringerung des Rechenbedarfs gewünscht, so wird nur ein einziger Zeitabschnitt in erfindungsgemäßer Weise bestimmt und dafür das Verfahren durchgeführt. Bei länger andauernden Ladezyklen wird damit der finale Zeitabschnitt, also der letztmögliche Zeitabschnitt verwendet, so dass der bestimmte Ladestand des Energiespeichers dem möglichst nahe kommt, welcher am Ende des Ladezyklus vorliegt.

Weiterer Gegenstand der vorliegenden Erfindung ist eine Kontrollvorrichtung für die Bestimmung des Ladestandes eines Energiespeichers während des Ladevorganges des Energiespeichers. Diese Kontrollvorrichtung weist eine Recheneinheit auf. Diese Recheneinheit ist ausgebildet für die Durchführung der folgenden Schritte:
- Überwachen der Ladespannung,
- Bestimmen eines Zeitabschnittes mit im Wesentlichen konstanter Ladespannung,
- Bestimmung der Ladestromsteigung und des Ladestroms in dem Zeitabschnitt mit im Wesentlichen konstanter Ladespannung,
- Bestimmung von Ladestandwerten des Energiespeichers aus Kalibrationskurven der Ladestromsteigung und des Ladestroms mit den bestimmten Werten der Ladestromsteigung und des Ladestroms
- Erzeugen eines Minimalwertes aus den bestimmten Ladestandwerten als Ladestand des Energiespeichers.

Eine erfindungsgemäße Kontrollvorrichtung ist vorzugsweise dahingehend weitergebildet, dass die Recheneinheit ausgebildet ist für die Durchführung eines erfindungsgemäßen Verfahrens. Damit bringt eine erfindungsgemäße Kontrollvorrichtung die gleichen Vorteile mit sich, wie sie ausführlich mit Bezug auf ein erfindungsgemäßes Verfahren erläutert worden sind.

Die vorliegende Erfindung wird näher erläutert anhand der beigefügten Zeichnungsfiguren. Es zeigen schematisch:
- Fig. 1: Einen generellen Zusammenhang zwischen SOC und Spannung, Strom und Stromsteigung,
- Fig. 2: eine Möglichkeit einer Kalibrationskurve in Form einer Kalibrationsfläche für eine Ladestromsteigung,
- Fig. 3: eine Möglichkeit einer Kalibrationskurve in Form einer Kalibrationsfläche des Ladestroms,
- Fig. 4: eine Variante der Durchführung eines erfindungsgemäßen Verfahrens und
- Fig. 5: eine Ausführungsform einer erfindungsgemäßen Kontrollvorrichtung.

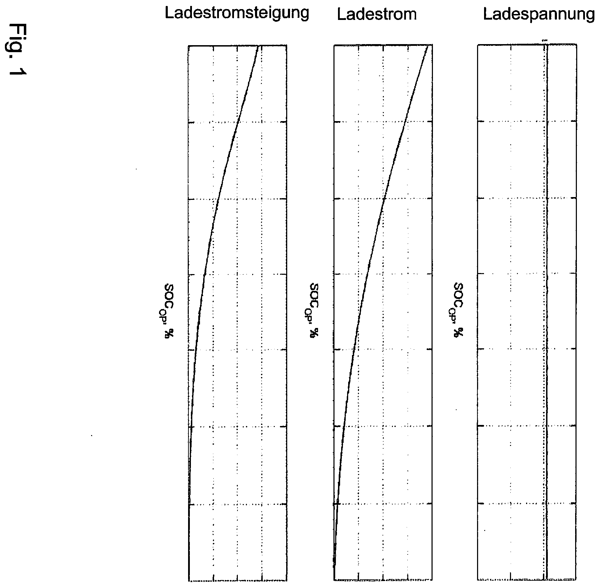

In Figur 1 ist eine Möglichkeit eines grundsätzlichen Zusammenhangs dargestellt. Insbesondere wird ein solcher Zustand aufgenommen auf einen Teststand, auf welchem ein Energiespeicher 10 geladen wird. Ein solcher Energiespeicher 10 ist insbesondere eine Batterie, vorzugsweise eine Blei-Säure-Batterie.

Beim Laden unter definierten Umgebungsbedingungen, z. B. auf einem Teststand, wird der Energiespeicher 10 mit vorgegebener und im Wesentlichen konstanter Ladespannung geladen. Bei Fahrzeugen liegt diese im Bereich zwischen 14V und 15V, z. B. bei einer Bordspannung von 14V. Als SOC (State of Charge) ist der Ladestand angegeben. Der Ladestrom nimmt bei zunehmendem Ladestand des Energiespeichers 30 ab, wie dies aus der mittleren Graphik der Figur 1 zu erkennen ist. Dementsprechend nimmt auch die Ladestromsteigung ab, wie es die untere Graphik der Figur 1 zeigt.

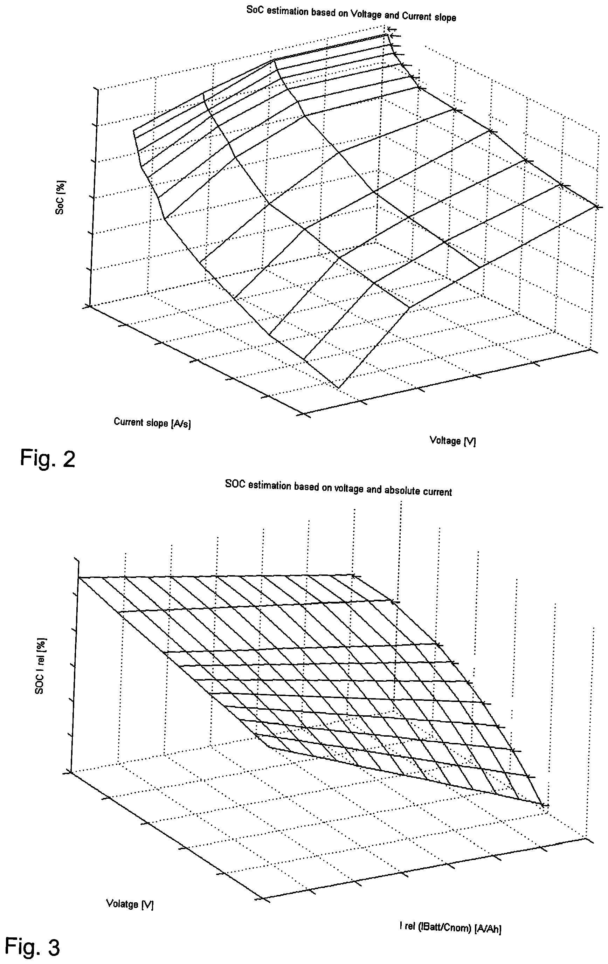

Die Figuren 2 und 3 zeigen aufgenommene Kalibrationsflächen, welche aus einer Vielzahl von Kalibrationskurven gemäß der Figur 1 erzeugt worden sind. Sie erstrecken sich in Figur 2 zusätzlich über eine Vielzahl unterschiedlicher konstanter Ladespannungen zwischen 14V und 16V für die Ladestromsteigung. Gleiches gilt für Figur 3 mit Bezug auf den Ladestrom.

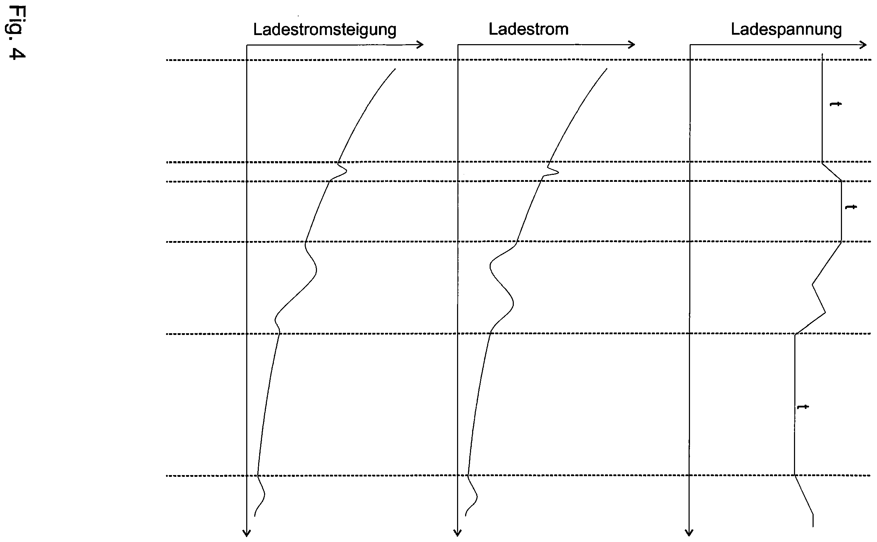

In Figur 4 ist eine Variante der Durchführung eines erfindungsgemäßen Verfahrens schematisch dargestellt. Die Ladespannung wird zeitlich überwacht. Es sind einzelne Zeitabschnitte t gekennzeichnet, in welchen die Ladespannung im Wesentlichen konstant ist. Die Ladespannung schwankt dabei häufig im Bereich von wenigen Volt zwischen 14V und 14,4V. Über diesen Verlauf werden der Ladestrom und die Ladestromsteigung mitbestimmt. In den einzelnen Zeitabschnitten t wird, sofern sie länger als eine vorbestimmte Zeitdauer, z. B. im Bereich von ca. 8 Minuten liegen, der Wert bzw. die Werte für den Ladestrom und die Ladestromsteigung mit den Kalibrationskurven verglichen. Insbesondere erfolgt ein Einsetzen der ermittelten Werte für Ladestrom und Ladestromsteigung in die Kalibrationskurven gemäß Figur 1 bzw. die Kalibrationsflächen gemäß Figur 2 und Figur 3. Im Rahmen der vorliegenden Erfindung ist unter einer Kalibrationskurve selbstverständlich auch eine Kalibrationsfläche und umgekehrt zu verstehen oder eine mathematische Funktion.

Auf diese Weise kann in den Kalibrationskurven der entsprechend zugehörige Ladestand (SOC) abgelesen werden, so dass der Ladestand des Energiespeichers 10 für jeden einzelnen gemessenen Wert des Ladestroms und der Ladestromsteigung zugeordnet werden kann. Aus dem sich ergebenden Ladestand wird ein Minimalwert berechnet und als Ladestand des Energiespeichers 10 gesetzt bzw. erzeugt.

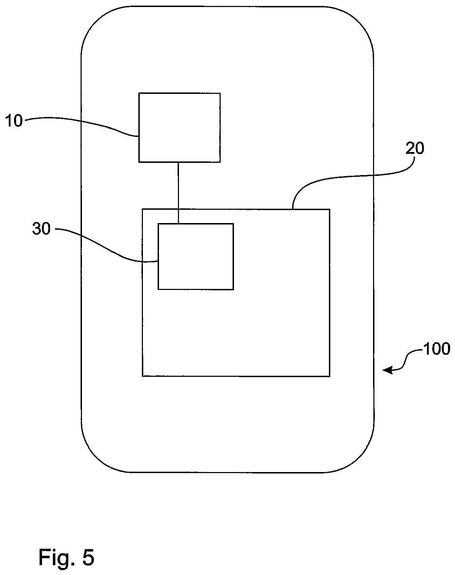

Figur 5 zeigt schematisch eine grundsätzliche Ausführungsform einer erfindungsgemäßen Kontrollvorrichtung 20. Diese weist eine Recheneinheit 30 auf, welche wiederum mit einem Energiespeicher 10 in signalkommunizierender Verbindung steht. Auf diese Weise kann während eines Ladezyklus sowohl die Ladespannung, als auch Ladestrom und Ladestromsteigung überwacht werden. Das Ganze erfolgt vorzugsweise innerhalb eines Fahrzeuges 100, bevorzugt eines Kraftfahrzeugs.

Die voranstehende Beschreibung der Ausführungsformen erläutert die vorliegende Erfindung nur im Rahmen von Beispielen. Dementsprechend können die Merkmale einzelner Ausführungsformen, sofern technisch sinnvoll, frei miteinander kombiniert werden, ohne den Rahmen der vorliegenden Erfindung zu verlassen.

### Bezugszeichenliste

- 10: Energiespeicher
- 20: Kontrollvorrichtung
- 30: Recheneinheit
- 100: Fahrzeug
- t: Zeitabschnitt mit im Wesentlichen konstanter Ladespannung

## Patentansprüche

1. Verfahren für die Bestimmung des Ladestandes eines Energiespeichers (10) während des Ladevorgangs des Energiespeichers (10), aufweisend die folgenden Schritte:
- Überwachen der Ladespannung,
- Bestimmen eines Zeitabschnitts (t) mit im Wesentlichen konstanter Ladespannung,
**dadurch gekennzeichnet, dass** das Verfahren zusätzlich die folgenden Schritte aufweist:
- Bestimmen der Ladestromsteigung und des Ladestroms in dem Zeitabschnitt (t) mit im Wesentlichen konstanter Ladespannung,
- Bestimmen von Ladestandwerten des Energiespeichers (10) aus Kalibrationskurven der Ladestromsteigung und des Ladestroms
- Erzeugen eines Minimalwerts aus den bestimmten Ladestandwerten als Ladestand des Energiespeichers (10).

2. Verfahren nach Anspruch 1, **dadurch gekennzeichnet, dass** der Energiespeicher (10) eine Batterie ist, insbesondere in Form einer Blei-Säure-Batterie.

3. Verfahren nach einem der vorangegangenen Ansprüche, **dadurch gekennzeichnet, dass** die Länge des Zeitabschnitts größer oder gleich 5 Minuten, bevorzugt größer oder gleich 6 Minuten, besonders bevorzugt größer oder gleich 7 Minuten, insbesondere größer oder gleich 8 Minuten beträgt.

4. Verfahren nach einem der vorangegangenen Ansprüche, **dadurch gekennzeichnet, dass** eine Temperaturkompensation durchgeführt wird, bei welcher der bestimmte Ladestand des Energiespeichers (10) mit Bezug zur gemessenen Temperatur des Energiespeichers (10) angepasst wird.

5. Verfahren nach einem der vorangegangenen Ansprüche, **dadurch gekennzeichnet, dass** eine Volladestanderkennung des Energiespeichers (10) durchgeführt wird, indem bei Annäherung der bestimmten Ladestromsteigung gegen Null, insbesondere einem kleinen absoluten Stromwert, der Energiespeicher (10) als vollgeladen bestimmt wird.

6. Verfahren nach einem der vorangegangenen Ansprüche, **dadurch gekennzeichnet, dass** zumindest eine Kalibrationskurve als mathematische Funktion vorgesehen ist, um durch Einsetzen des zugehörigen bestimmten Wertes der Ladestromsteigung und/oder des Ladestroms in diese mathematische Funktion den zugehörigen Ladestandwert des Energiespeichers (10) zu bestimmen.

7. Verfahren nach einem der vorangegangenen Ansprüche, **dadurch gekennzeichnet, dass** eine Bestimmung der Kapazität des Energiespeichers (10) durchgeführt wird, indem der bestimmte Ladestand des Energiespeichers (10) mit einem aus der Ruhespannung bestimmten Ladestand des Energiespeichers (10) verglichen wird.

8. Verfahren nach einem der vorangegangenen Ansprüche, **dadurch gekennzeichnet, dass** bei der Bestimmung von wenigstens zwei Zeitabschnitten (t) mit im Wesentlichen konstanter Ladespannung der mit Bezug auf die Dauer des Ladezyklus des Energiespeichers (10) spätere Zeitabschnitt (t) für die weiteren Schritte des Verfahrens verwendet wird.

9. Kontrollvorrichtung (20) für die Bestimmung des Ladestandes eines Energiespeichers (10) während des Ladevorgangs des Energiespeichers (10), aufweisend wenigstens eine Recheneinheit (30), wobei die Recheneinheit (30) ausgebildet ist für die Durchführung der folgenden Schritte:
- Überwachen der Ladespannung,
- Bestimmen eines Zeitabschnitts mit im Wesentlichen konstanter Ladespannung,
**dadurch gekennzeichnet, dass** die Recheneinheit (30) zusätzlich für die Durchführung der folgenden Schritte ausgebildet ist:
- Bestimmen der Ladestromsteigung und des Ladestroms in dem Zeitabschnitt mit im Wesentlichen konstanter Ladespannung,
- Bestimmen von Ladestandwerten des Energiespeichers (10) aus Kalibrationskurven der Ladestromsteigung und des Ladestroms mit den bestimmen Werten der Ladestromsteigung und des Ladestroms
- Erzeugen eines Minimalwerts aus den bestimmten Ladestandwerten als Ladestand des Energiespeichers (10).

10. Kontrollvorrichtung (10) nach Anspruch 9, **dadurch gekennzeichnet, dass** die Recheneinheit (30) ausgebildet ist für die Durchführung eines Verfahrens mit den Merkmalen eines der Ansprüche 1 bis 8.

## Claims

1. Procedure for the determination of the charge level of an energy storage device (10) during the charging process of the energy storage device (10), comprising the following steps:
- Monitoring of the charging voltage,
- Determination of the time period (t) with essentially constant charging voltage,
**characterized in that** the procedure comprises the following steps in addition:
- Determination of the charging current increase and the charging current during the time period (t) with essentially constant charging voltage,
- Determination of charge level rates of the energy storage device (10) on the basis of calibration curves of the charging current increase and the charging current,
- Determination of a minimum value as charge level of the energy storage device (10) from the determined charge level values.

2. Procedure according to Claim 1, **characterized in that** the energy storage device (10) is a battery, particularly in the form of a lead-acid battery.

3. Procedure according one of the previous Claims, **characterized in that** the length of the time period is larger or equal 5 minutes, preferably larger or equal 6 minutes, particularly larger or equal 8 minutes.

4. Procedure according one of the previous Claims, **characterized in that** temperature compensation is executed, in which the determined charge level of the energy storage device (10) is adapted in relation to the measured temperature of the energy storage device (10).

5. Procedure according one of the previous Claims, **characterized in that** a battery full detection of the energy storage device (10) is executed by determining the energy storage device (10) as fully loaded when the determined charging current increase approaches zero, particularly at a small absolute current value.

6. Procedure according one of the previous Claims, **characterized in that** at least one calibration curve is provided as a mathematical function to determine the associated charge level value of the energy storage device (10) by insertion of the associated, determined value of the current charge increase and/ or the charging current into this mathematical function.

7. Procedure according one of the previous Claims, **characterized in that** a determination of the capacity of the energy storage device (10) is executed by comparing the determined charge level of the energy storage device (10) with a charge level of the energy storage device (10) determined at off-load voltage.

8. Procedure according one of the previous Claims, **characterized in that** during the determination of at least two time periods (t) with essentially constant charging voltage, the later time period (t), when referred to the duration of the charging cycle of the energy storage device (10) is used for the further steps of the procedure.

9. Monitoring device (20) for the determination of the charge level of an energy storage device (10) during the charging procedure of the energy storage device (10), comprising at least one processing unit (30), wherein the processing unit (30) is embodied for the execution of the following steps:
- monitoring of the charging voltage,
- determination of a time period with essentially constant charging voltage,
**characterized in that** the processing unit (30) is additionally embodied to execute the following steps:
- Determination of the charging current increase and the charging current during the time period with essentially constant charging voltage,
- Determination of charge level rates of the energy storage device (10) on the basis of calibration curves of the charging current increase and the charging current with the determined values of the charging current increase and the charging current
- Determination of a minimum value as charge level of the energy storage device (10) from the determined charge level values.

10. Monitoring device (10) according to Claim 9, **characterized in that** the processing unit (30) is embodied for the execution of a procedure with the characteristics of one of the Claims 1 to 8.

## Revendications

1. Procédé pour la détermination de l'état de charge d'un réservoir d'énergie (10) pendant le processus de charge du réservoir d'énergie (10), présentant les étapes suivantes :
- surveillance de la tension de charge,
- détermination d'une période (t) à tension de charge essentiellement constante,
**caractérisé en ce que**
le procédé présente en plus les étapes suivantes :
- détermination de la montée de courant de charge et du courant de charge pendant la période (t) à tension de charge essentiellement constante,
- détermination des valeurs de l'état de charge du réservoir d'énergie (10) à partir des courbes de calibrage de la montée de courant de charge et du courant de charge,
- génération d'une valeur minimale à partir des valeurs de l'état de charge déterminées en tant qu'état de charge du réservoir d'énergie (10).

2. Procédé selon la revendication 1,
**caractérisé en ce que** le réservoir d'énergie (10) est une batterie, surtout sous forme d'une batterie au plomb-acide.

3. Procédé selon l'une des revendications précédentes,
**caractérisé en ce que** la longueur de la période est supérieure ou égale à 5 minutes, de préférence supérieure ou égale à 6 minutes, tout particulièrement supérieure ou égale à 7 minutes, notamment supérieure ou égale à 8 minutes.

4. Procédé selon l'une des revendications précédentes,
**caractérisé en ce qu'une** compensation de température est effectuée pendant laquelle l'état de charge déterminé du réservoir d'énergie (10) est adapté par rapport à la température mesurée du réservoir d'énergie (10).

5. Procédé selon l'une des revendications précédentes,
**caractérisé en ce qu'une** identification de charge maximale du réservoir d'énergie (10) est effectuée en déterminant le réservoir d'énergie (10) comme complètement chargé lors de l'approche de la montée de courant de charge déterminée vers zéro, notamment une faible valeur de courant absolue.

6. Procédé selon l'une des revendications précédentes, **caractérisé en ce qu'au** moins une courbe de calibration est prévue en tant que fonction mathématique pour déterminer la valeur de l'état de charge correspondante du réservoir d'énergie (10) en insérant la valeur déterminée correspondante de la montée de courant de charge et/ou du courant de charge dans cette fonction mathématique.

7. Procédé selon l'une des revendications précédentes,
**caractérisé en ce qu'une** détermination de la capacité du réservoir d'énergie (10) est effectuée en comparent l'état de charge déterminé du réservoir d'énergie (10) avec l'état de charge du réservoir d'énergie (10) déterminé à partir de la tension de repos.

8. Procédé selon l'une des revendications précédentes,
**caractérisé en ce que** lors de la détermination d'au moins deux périodes (t) à tension de charge essentiellement constante, la période (t) ultérieure quant à la durée du cycle de charge du réservoir d'énergie (10) est utilisée pour les étapes suivantes du procédé.

9. Dispositif de contrôle (20) pour la détermination de l'état de charge d'un réservoir d'énergie (10) pendant le processus de charge du réservoir d'énergie (10), présentant au moins une unité de contrôle (30), l'unité de contrôle (30) étant configurée pour la réalisation des étapes suivantes :
- surveillance de la tension de charge,
- détermination d'une période à tension de charge essentiellement constante,
**caractérisé en ce que** l'unité de contrôle (30) est configurée en plus pour la réalisation des étapes suivantes :
- détermination de la montée de courant de charge et du courant de charge pendant la période à tension de charge essentiellement constante,
- détermination des valeurs de l'état de charge du réservoir d'énergie (10) à partir des courbes de calibrage de la montée de courant de charge et du courant de charge avec les valeurs déterminées de la montée de courant de charge et du courant de charge,
- génération d'une valeur minimale à partir des valeurs de l'état de charge déterminées en tant qu'état de charge du réservoir d'énergie (10).

10. Dispositif de contrôle (10) selon la revendication 9,
**caractérisé en ce que** l'unité de contrôle (30) est configurée pour la réalisation d'un procédé avec les caractéristiques d'une des revendications 1 à 8.
